Europäisches Patentamt

European Patent Office

Office européen des brevets

(11) Veröffentlichungsnummer: **0 113 892**
**B1**

(12) # EUROPÄISCHE PATENTSCHRIFT

(45) Veröffentlichungstag der Patentschrift: **02.03.88**

(51) Int. Cl.⁴: **H 03 K 5/08**, H 03 K 5/153

(21) Anmeldenummer: **83112654.5**

(22) Anmeldetag: **15.12.83**

(54) **Signaldetektor.**

(30) Priorität: **20.12.82 DE 3247137**

(43) Veröffentlichungstag der Anmeldung:
**25.07.84 Patentblatt 84/30**

(45) Bekanntmachung des Hinweises auf die
Patenterteilung:
**02.03.88 Patentblatt 88/09**

(84) Benannte Vertragsstaaten:
**DE FR GB IT NL SE**

(56) Entgegenhaltungen:
**GB-A-2 100 085
US-A-3 763 436
US-A-3 863 160

1982 IEEE MTT-S INTERNATIONAL
MICROWAVE SYMPOSIUM DIGEST, 15.-17,
Juni 1982, Dallas, Texas, US, Seiten 80-82,
IEEE, New York, US; P. WAHI et al.:
"Simultaneous Pulse Separator"**

(73) Patentinhaber: **ELTRO GmbH Gesellschaft für
Strahlungstechnik
Kurpfalzring 106 Postfach 10 21 20
D-6900 Heidelberg 1 (DE)**

(72) Erfinder: **Strauss, Manfred
Klingenhüttenweg 7a
D-6900 Heidelberg (DE)**
Erfinder: **Welz, Wolfgang
Ringstrasse 73
D-6901 Bammental (DE)**

(74) Vertreter: **Muschka, Wilhelm, Dipl.-Ing.
Eltro GmbH Gesellschaft für Strahlungstechnik
Kurpfalzring 106 Postfach 10 21 20
D-6900 Heidelberg 1 (DE)**

Courier Press, Leamington Spa, England.

## Beschreibung

Die Erfindung bezieht sich auf ein Verfahren zum Empfang bestimmter Impulse nach dem Oberbegriff des Patentanspruchs 1 sowie auf eine Schaltungsanordnung zur Durchführung dieses Verfahrens.

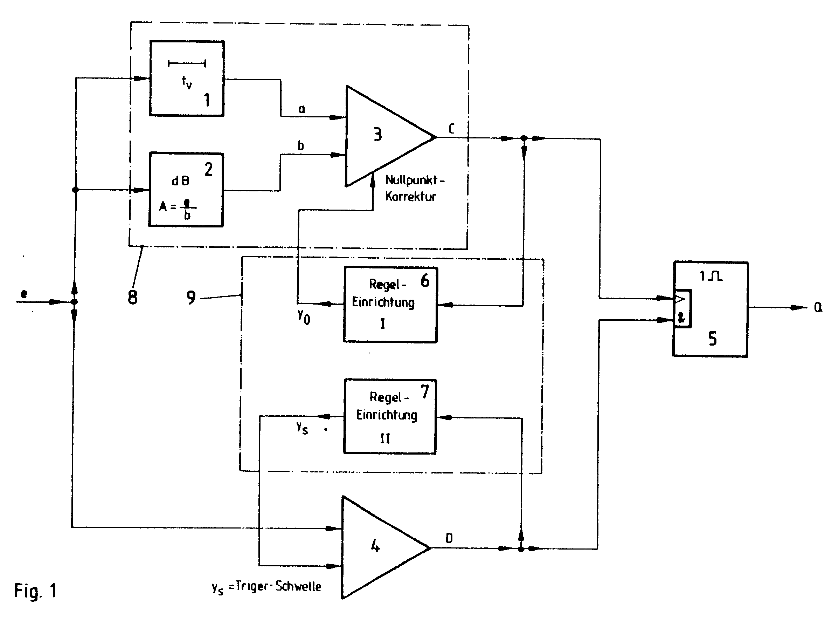

Eine solche Schaltungsanordnung ist aus US—A 3.763.436, insbesondere Fig. 1, bekannt. Mit ihr lassen sich Ausgangsimpulse mit präzisem Schaltzeitpunkt relativ zum Eingangsimpuls sowie unabhängig von dessen Amplitude erzeugen. Die Zeitmessung erfolgt hier unabhängig vom ankommenden Signal. Für eine genaue Triggerschwelle kann man — ob die Signalamplitude schwankt oder nicht — z.B. eine Offset-Spannung verwenden, wobei zur Auswertung die abfallende Flanke der Amplitude herangezogen wird. Insofern wird auch hier ein Schwellwert gesetzt.

Aus der DE—A1— 29 12 653 ist ein Konstant-Bruchteil-Diskriminator bekannt, der ein bipolares Ausgangssignal erzeugt, bei dem mit dem Ausgang des Signal-Teilungsgliedes ein Verzögerungsglied verbunden ist, Eine Schwellwertschaltung ist hier nicht vorgesehen.

Dem Anmeldungsgegenstand liegt die Aufgabe zugrunde, das gattungsgemäße Verfahren so zu verbessern, daß stark schwankende und dicht aufeinander folgende oder ineinander geschobene Impulse besser detektiert werden können. Diese Aufgabe wird bei dem Verfahren der eingangs beschriebenen Art erfindungsgemäß durch die im kennzeichnenden Teil des Anspruchs 1 angegebenen Merkmale gelöst. Diese vor allem bei zwei oder mehr solcher Impulse vorteilhafte Methode gewährleistet mit vergleichsweise geringem elektronischen Aufwand eine sichere zeitliche Auflösung.

Eine Weiterbildung der Erfindung wird in der Schaltungsanordnung zur Durchführung des Verfahrens nach Anspruch 7 gesehen. Die Regeleinrichtungen nach Anspruch 8 hingegen ermöglichen eine gewisse Automatisierung. Mit der einen kann der Triggerpegel des zugehörigen Differenzdiskriminators so eingestellt werden, daß die Störwahrscheinlichkeit der Schaltung einen vordefinierten Wert nicht überschreitet, während mit der anderen die Offset-Fehler auf ein Minimum reduziert werden.

Die restlichen Unteransprüche enthalten zusätzliche Weiterbildungen der Erfindung.

Im folgenden werden an Hand von Zeichnungen Ausführungsbeispiele der Erfindung näher erläutert, wobei die in den einzelnen Figuren einander entsprechenden Teile dieselben Bezugszahlen aufweisen. Es zeigt.

Fig. 1 die erfindungsgemäße Schaltungsanordnung als Blockschaltbild,

Fig. 2 einen Einzelimpuls mit großer Amplitude,

Fig. 3 einen Einzelimpuls mit kleiner Amplitude,

Fig. 4 einen Doppelimpuls mit gleicher Amplitude und

Fig. 5 einen Doppelimpuls mit unterschiedlicher Amplitude.

Die strichpunktierte Umrandung 8 in Fig. 1 symbolisiert den Konstant-Bruchteil-Diskriminator, der im wesentlichen aus dem Analog-Verzögerungsglied 1, dem mit einem Dämpfungsfaktor A = e/b versehenen Signal-Dämpfungsglied 2 und einem ersten Differenzdiskriminator 3 besteht. An den Eingängen des Analogverzögerungsgliedes 1, des Signal-Dämpfungsgliedes 2 sowie eines zweiten Differenzdiskriminators 4 liegen hierbei gleichzeitig der empfangene Originalimpuls e an. Das Analog-Verzögerungsglied leitet diesen Originalimpuls e mit gleicher äußerer Erscheinungsform, das heißt mit gleicher Amplitudenhöhe und -breite, jedoch zeitverzögert, als Impuls a an einen Eingang des ersten Differenzdiskriminators 3, während das Signal-Dämpfungsglied den Originalimpuls e durch einen Faktor A teilt, das heißt ihn bei gleichbleibender Amplitudenbreite in seiner Amplitudenhöhe mindert und ihn als Impuls b an einen anderen Eingang dieses Diskriminators leitet. Von hier aus gelangt der verarbeitete Impuls als Signal C an die Logik 5 sowie unter Berücksichtigung des auch von dem zweiten Differenzdiskriminator 4 an die Logik übermittelten Signals D als Signal Q an die weitere, zeichnerisch nicht dargestellte Verarbeitung. Die Logik besteht im einfachsten Fall aus einem Monostabil-Multivibrator, der nur dann getriggert wird, wenn D und die positive Flanke C vorhanden sind. Der Teilungsfaktor und die Zeitverzögerung müssen hierbei so gewählt sein, daß bei den infrage kommenden Impulsen mit stark schwankenden Amplituden, ineinandergeschobenen oder dicht aneinandergereihten Impulsen mit im Verhältnis zum Anstieg größerer Impulsbreite, anders gearteter Abfallflanke und gegebenenfalls Überlagerung höherfrequenter Signalanteile mit geringer Amplitude die Rückflanke keinen weiteren Trigger auslöst, falls kein zweiter Impuls in dem Zeitraum der Abfallflanke vorhanden ist. Außerdem muß der Pulsdetekter eine solche Triggerschwelle aufweisen, daß die Störwahrscheinlichkeit einen vordefinierten Wert nicht überschreitet.

Mit einer weiteren strichpunktierten Linienführung ist die aus den beiden Regeleinrichtungen 6 und 7 bestehende Automatik 9 für eine maximale Detektionsempfindlichkeit bezeichnet, die nicht zwingend aber vorteilhafterweise vorgesehen ist. Erstere ist eine Offset-Regelschaltung, die zur Nullpunktkorrektur zwischen den Ausgang und einem Offsetstelleingang des Differenzdiskriminators 3 geschaltet ist und selbsttätig die Offsetfehler auf ein Minimum reduziert; das regelnde Signal ist mit $y_0$ bezeichnet. Zwischen Aus- und Eingang des Differenzdiskriminators 4 dagegen ist die andere Regeleinrichtung geschaltet; letztere dient als Störwahrscheinlichkeits-Regelschaltung, deren Signal $y_s$ dem Diskriminator als Triggerschwelle so zugeführt wird, daß die Störwahrscheinlichkeit einen vordefinierten Wert nicht überschreitet.

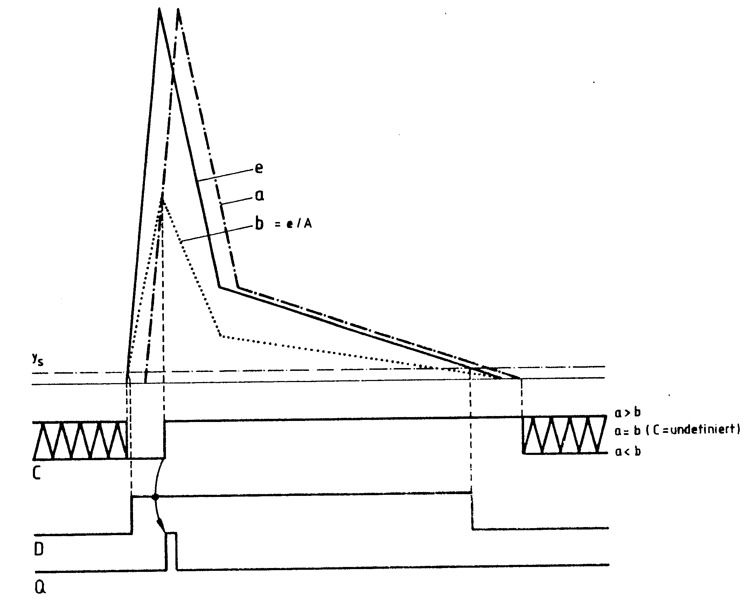

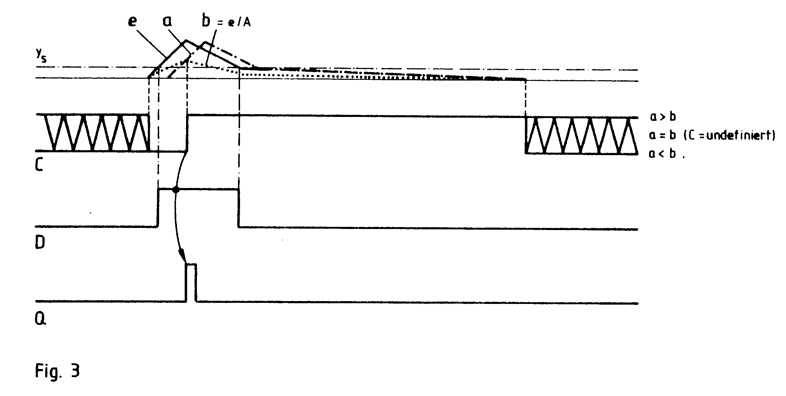

Die Figuren 2 bis 5 zeigen verschiedene Anwendungsfälle des erfindungsgemäßen Verfahrens: Im einfachsten Fall der Fig. 2 und 3 besitzt der Originalimpuls e eine große Amplitude. Mit der Triggerschwelle $y_s$ des Differenzdiskriminators 4 (Fig. 1) wird über die Anstiegsflanke der gesamte empfangene Impuls wahrgenommen. Gleichzeitig wird in der vorbeschriebenen Weise ein zeitlich verzögerter Impuls a mit gleicher Amplitudenausbildung sowie ein Impuls b gebildet, dessen Amplitude um den Teilungsfaktor A lediglich in ihrer Höhe verringert ist. Die beiden Signal a und b werden über den Differenzdiskriminator 3 miteinander verglichen. Am Eingang des Diskriminators 3 ist zunächst der Impuls b vorhanden. Da a < b ist, verursacht dieser am Ausgang eine logische Null. Nach der Zeitverzögerung wird a > b und damit ergibt sich am Ausgang ein Signalsprung auf logisch Eins.

Die Impulsdiagramme C, D und Q unterhalb des Impulsschaubildes entsprechen hierbei einzelnen Rechenoperationen wie sie sich in der Schaltungsanordnung gemäß Fig. 1 an den Ausgängen der beiden Differenzdiskriminatoren 3 und 4 sowie der Logik 5 darstellen. Das Diagramm C ergibt sich hierbei aus einem Vergleich des gedämpften Impulses b und des verzögerten Impulses a, wobei vor Beginn des Originalimpulses und nach Ausklingen des verzögerten Impulses auch der Rauschpegel angedeutet ist. Ein Ergebnis ist hierbei jeweils nur bei a > b oder a < b zu erwarten; im Fall von a = b bleibt C undefiniert. Das Diagramm D zeigt sodann den Originalimpuls e unter Berücksichtigung der Triggerschwelle. Die Signalvergleiche können aktiv, passiv oder über einen Rechner erfolgen.

Die Ausführungsbeispiele der Fig. 2 und 3 entsprechen einander bis auf unterschiedliche Größen der Amplituden. Beide haben ihrer Einfachheit und Übersichtlichkeit wegen vor allem für Erläuterungszwecke Bedeutung, weniger dagegen für die Praxis, wo dieses Verfahren einer besseren Auflösung eines oder mehrerer weiterer Impulse dienen soll, die ansonsten — sofern sie jedenfalls oberhalb der Triggerschwelle im Bereich der sich abflachenden Rückflanke der Amplitude zu liegen kommen — verloren gingen. Die Anwendung bei nur einem Impuls zeigt lediglich, daß kein weiterer Impuls vorhanden ist.

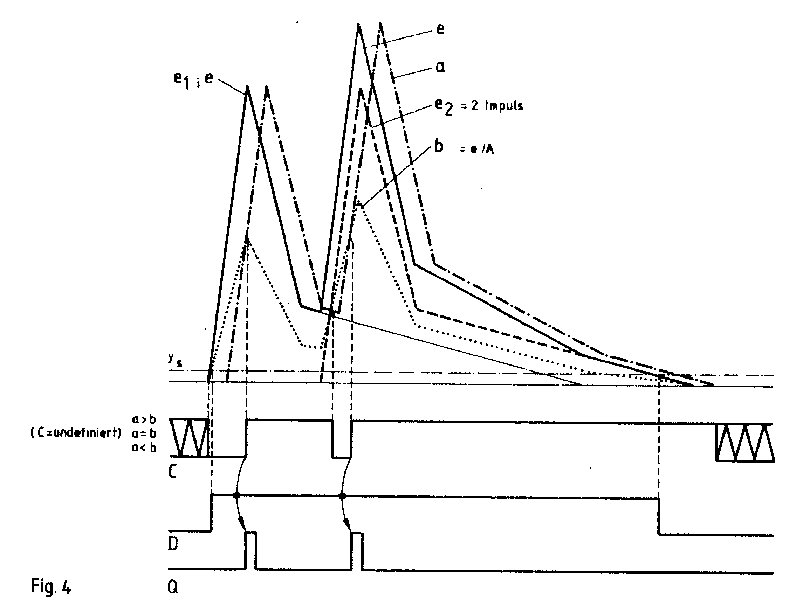

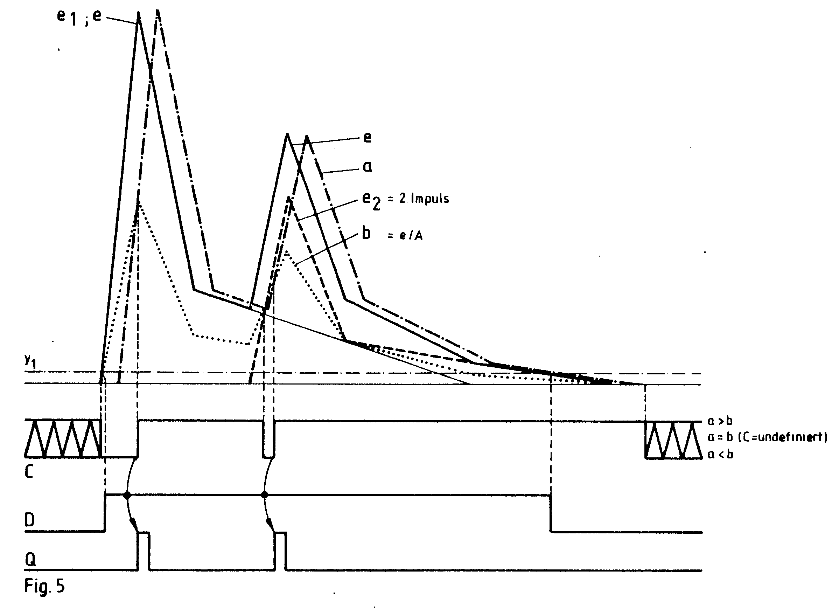

Die Fig. 4 und 5 weisen dieselben Rechenoperationen und Darstellungsweisen mit jeweils zwei Impulsen $e_1$ und $e_2$ aus. Im ersteren Fall besitzen beide Impulse gleiche, im anderen unterschiedliche Amplituden. Zusätzlich ist bei diesen Ausführungsbeispielen noch mit starker Linienführung die Hüllkurve $e = e_1 + e_2$ dargestellt, die sich jeweils durch die Überlagerung der Impulse $e_1$ und $e_2$ ergibt. Die Hüllkurve fällt jeweils im Bereich des ersten Impulses $e_1$ mit diesem zusammen. Von Bedeutung sind Verfahren und Anordnung in der Strahlungsmeßtechnik, wie z.B. für die Kern-, Sonar-, Laserstrahlung usw.

**Patentansprüche**

1. Verfahren zum Empfang von in ihrer Amplitude stark schwankenden, dicht aufeinanderfolgenden oder ineinander geschobenen Impulsen mit einer im Verhältnis zu ihrer Anstiegsflanke großen Impulsbreite, anders gearteter Abfallflanke und gegebenenfalls einer Überlagerung höher frequenter Signalanteile mit geringer Amplitude, wobei

a) nur eine Flanke eines jeweiligen Impulses verwendet und die andere unterdrückt wird,

b) der empfangenen Impuls zum einen über ein Verzögerungsglied vorgegebener Verzögerung verzögert, zum anderen in einem vorgegebenen Maße bedämpft und der verzögerte mit dem bedämpften Impuls verglichen wird,

dadurch gekennzeichnet, daß

c) der empfangene Impuls zusätzlich mit einem durch Störsignale bedingten Referenzsignal (Störwahrscheinlichkeit) verglichen wird und

d) daß die die Resultate der beiden Vergleiche repräsentierenden Signale miteinander verknüpft werden.

2. Verfahren nach Anspruch 1, dadurch gekennzeichnet, daß nur die Anstiegsflanke des jeweiligen Impulses verwendet und die Abfallflanke unterdrückt wird.

3. Verfahren nach Anspruch 1 oder 2, dadurch gekennzeichnet, daß der verzögerte und der bedämpfte Impuls passiv oder mit Hilfe eines Rechners verglichen werden.

4. Verfahren nach Anspruch 3, dadurch gekennzeichnet, daß der Vergleich mittels eines Amplitudendiskriminators (3) vorgenommen wird.

5. Verfahren nach Anspruch 1 oder einem der folgenden, dadurch gekennzeichnet, daß das Referenzsignal an Hand einer vorgegebenen Störwahrscheinlichkeit in einer Regeleinrichtung (7) ermittelt wird.

6. Verfahren nach Anspruch 5, dadurch gekennzeichnet, daß die Störwahrscheinlichkeit automatisch ermittelt wird.

7. Schaltungsanordnung zur Durchführung des Verfahrens nach einem der vorausgehenden Ansprüche unter Verwendung eines Konstant-Bruchteil-Diskriminators, dadurch gekennzeichnet, daß

a) die empfangen Impulse gleichzeitig an Eingängen eines weiteren Amplitudendiskriminators (4) sowie eines im wesentlichen aus einem Verzögerungsglied (1), einem Impuls-Dämpfungsglied (2) und dem ersten Amplitudendiskriminator (3) bestehenden Konstant-Bruchteil-Diskriminators (8) anliegen und

b) die Ausgänge der Amplitudendiskriminatoren (3; 4) über eine Verknüpfungsschaltung (5) miteinander verbunden sind, die beim Zusammentreffen eines Impulses am Ausgang des zweiten Amplitudendiskriminators (4) mit einem Impulssprung am Ausgang des ersten Amplitudendiskriminators (3) ein Signal auslöst.

8. Schaltungsanordnung nach Anspruch 7, dadurch gekennzeichnet, daß

a) dem ersten Amplitudendiskriminator (3) eine aus einer Offset-Regelschaltung zur Nullpunktkorrektur bestehende Regeleinrichtung (6) zugeordnet ist, und

b) dem zweiten Amplitudendiskriminator (4) eine weitere als Triggerschwelle dienende Regeleinrichtung (7) zugeordnet ist, deren Signal $y_s$ dem Diskriminator so zugeführt wird, daß die Störwahrscheinlichkeit einen vordefinierten Wert nicht überschreitet.

9. Schaltungsanordnung nach Anspruch 8, dadurch gekennzeichnet, daß das eine Ende jeder Regeleinrichtung (6; 7) jeweils an dem Ausgang des ihm zugeordneten Amplitudendiskriminators (3; 4) anliegt, während das andere Ende der dem ersten Amplitudendiskriminator (3) zugeordneten Regeleinrichtung (6) an dem Offsetstelleingang und das andere Ende der dem zweiten Amplitudendiskriminator (4) zugeordneten Regeleinrichtung (7) am Bezugseingang anliegen.

**Revendications**

1. Procédé pour recevoir des impulsions, dont l'amplitude varie fortement et qui se succèdent d'une manière dense ou sont imbriquées les unes dans les autres, possèdent une durée importante par rapport à leur flanc ascendant, et ont un flanc descendant conformé différemment, et auxquelles sont éventuellement superposées des composantes de signaux à haute fréquence et possédant une faible amplitude, et selon lequel

a) seul un flanc d'une impulsion particulière est utilisé et l'autre est supprimé,

b) l'impulsion reçue est retardée d'un retard prédéterminé par l'intermédiaire d'un circuit de retardement et est d'autre part atténuée à un degré prédéterminé, et l'impulsion retardée est comparée à l'impulsion atténuée,

caractérisé en ce que

c) l'impulsion reçue est en outre comparée à un signal de référence conditionné par des signaux parasites (probabilité de parasitage), et

d) les signaux représentant les résultats des deux comparaisons sont combinés entre eux.

2. Procédé selon la revendication 1, caractérisé en ce que seul le flanc escendant de l'impulsion particulière est utilisé et le flanc descendant est supprimé.

3. Procédé selon la revendication 1 ou 2, caractérisé en ce que l'impulsion retardée et l'impulsion atténuée sont comparées d'une manière passive ou à l'aide d'un ordinateur.

4. Procédé selon la revendication 3, caractérisé en ce que la comparaison est réalisée au moyen d'un discriminateur d'amplitude (3).

5. Procédé selon la revendication 1 ou l'une des suivantes, caractérisé en ce que le signal de référence est déterminé sur la base d'une probabilité de parasitage prédéterminée dans un circuit de réglage (7).

6. Procédé selon la revendication 5, caractérisé en ce que la probabilité de parasitage est déterminée de façon automatique.

7. Montage pour la mise en oeuvre du procédé selon l'une des revendications précédentes, moyennant l'utilisation d'un discriminateur de fractions constantes, caractérisé en ce que

a) les impulsions reçues sont envoyées simultanément aux entrées d'un autre discriminateur d'amplitude (4) ainsi que d'un discriminateur de fractions constantes (8) constitué par un circuit de retardement (1), un circuit atténuateur d'impulsions (2) et le premier discriminateur d'amplitude (3), et

b) les sorties des discriminateurs d'amplitude (3, 4) sont reliées entre elles par l'intermédiaire d'un circuit combinatoire (5) qui déclenche un signal lorsqu'une impulsion apparaissant sur la sortie du second discriminateur d'amplitude (4) coïncide avec un saut d'impulsion présent sur la sortie du premier discriminateur (3).

8. Montage selon la revendication 7, caractérisé en ce que

a) au premier discriminateur d'amplitude (3) est associé un dispositif de réglage (6) constitué par un circuit de réglage du décalage du zéro servant à réaliser la correction du zéro, et

b) au second discriminateur d'amplitude (4) est associé un autre dispositif de réglage (7) utilisé en tant que dispositif à seuil de déclenchement et dont le signal $y_s$ est envoyé au discriminateur de manière que la probabilité de parasitage ne dépasse pas une valeur préalablement définie.

9. Montage selon la revendication 1, caractérisé en ce qu'une extrémité de chaque dispositif de réglage (6; 7) est raccordée respectivement à la sortie du discriminateur d'amplitude (3; 4), qui lui est associé, tandis que l'autre extrémité du dispositif de réglage (6) associé au premier discriminateur d'amplitude (3) est raccordée à l'entrée de réglage du décalage du zéro et que l'autre extrémité du dispositif de réglage (7) associé au second discriminateur d'amplitude (4) est raccordée à l'entrée de référence.

**Claims**

1. Process for receiving pulses, the amplitude of which fluctuates significantly, which follow each other closely in sequence or which are run into each other, with a large pulse width in relation to their leading edge, a trailing edge of another type, and, where applicable, a superimposition of higher frequency signal contents with a small amplitude, whereby

a) only one edge of a corresponding pulse is used and the other is suppressed and

b) the received pulse is first of all delayed by a preset delay through a delay device and then attenuated by a preset amount and the delayed pulse is compared with the attenuated pulse, characterised in that

c) the received pulse is also compared with a reference signal relating to interference signals (interference probability) and

d) in that the signals representing the results of the two comparisons are combined with each other.

2. Process according to claim 1, characterised in that only the leading edge of the corresponding pulse is used and the trailing edge is suppressed.

3. Process according to claim 1 or 2, characterised in that the delayed and the attenuated pulse are compared passively or with the aid of a computer.

4. Process according to claim 1 or one of the following claims, characterised in that the comparison is effected by means of an amplitude discriminator (3).

5. Process according to claim 1 or one of the following claims, characterised in that the reference signal is determined in a control system (7) with the aid of a preset interference probability.

6. Process according to claim 5, characterised in that the interference probability is determined automatically.

7. Circuit arrangement for carrying out the process according to one of the preceding claims using a constant fraction discriminator, characterised in that

a) the received pulses are present simultaneously at inputs of a further amplitude discriminator (4) as well as of a constant fraction discriminator (8) comprising basically a delay device (1), a pulse absorptive attenuator (2) and the first amplitude discriminator (3) and

b) the outputs of the amplitude discriminators (3; 4) are connected to each other via a combining circuit (5), which triggers a signal when a pulse at the output of the second amplitude discriminator (4) meets the pulse jump at the output of the first amplitude discriminator (3).

8. Circuit arrangement according to claim 7, characterised in that

a) a control system (6) comprising an offset control circuit for zero offset compensation is associated with the first amplitude discriminator (3) and

b) a further control system (7) used as a trigger threshold is associated with the second amplitude discriminator (4), whereby the signal $y_s$ of the control system is fed into the discriminator in such a way that the interference probability does not exceed a predefined value.

9. Circuit arrangement according to claim 8, characterised in that one end of each control system (6; 7) is always present at the output of the amplitude discriminator (3; 4) associated with it, whilst the other end of the control system (6) associated with the first amplitude discriminator (3) is associated with the offset control input and the other end of the control system (7) associated with the second amplitude discriminator (4) is associated with the reference input.

Fig. 1

$t_v$   1

dB   2
$A = \dfrac{a}{b}$

a

b

3   c   Nullpunkt-
Korrektur

8

9

Regel-
Einrichtung
I   6

$y_0$

Regel-
Einrichtung
II   7

$y_s$

4   D

1 ⏛   5

e

a

$y_s$ = Triger-Schwelle

0 113 892

a > b
a = b ( C = undefiniert )
a < b

e
a
b = e / A

$y_s$

C

D

Q

2

Fig. 3

e

a

$e_2 = 2 \text{ Impuls}$

$b = e/A$

$e_1 ; e$

$y_s$

(C=undefiniert)

a > b
a = b
a < b

C

D

Q

Fig. 4

Fig. 5